# EUROPÄISCHE PATENTSCHRIFT

(11) **EP 3 335 530 B1**
(45) Veröffentlichungstag und Bekanntmachung des Hinweises auf die Patenterteilung: **06.12.2023**
(21) Anmeldenummer: 16751285.4
(22) Anmeldetag: 10.08.2016
(51) Int. Cl.: H05K 5/02

(54) **SICHERUNGSRAHMEN FÜR EINEN USB-ANSCHLUSS**
SECURING FRAME FOR A USB CONNECTION
CADRE DE SÉCURITÉ POUR UN BRANCHEMENT USB

(30) Priorität: 10.08.2015 DE 102015113114
(43) Veröffentlichungstag der Anmeldung: 20.06.2018
(73) Patentinhaber: E.E.P.D Electronic Equipment Produktion & Distribution GmbH, 85258 Weichs (DE)
(72) Erfinder: BLERSCH, Christian, 85258 Weichs (DE)
(74) Vertreter: Betten & Resch
(86) Internationale Anmeldenummer: PCT/EP2016/069003
(87) Internationale Veröffentlichungsnummer: WO 2017/025548

(56) Entgegenhaltungen:
- US-A- 6 141 221
- US-A1- 2001 047 441
- US-A1- 2009 149 055
- US-A1- 2012 064 753
- US-A1- 2012 140 398
- US-B1- 6 796 844

## Beschreibung

Die vorliegende Erfindung betrifft einen Sicherungsrahmen für einen USB-Anschluss, einen USB-Verteiler (USB-Hub) mit einem derartigen Sicherungsrahmen sowie ein System umfassend einen derartigen Sicherungsrahmen und ein Steckermodul zur Verwendung in dem Sicherungsrahmen,

Der Universal Serial Bus (USB) ist ein serielles Bussystem zur Verbindung eines Computers mit externen Geräten. Mit USB-Anschlüssen ausgestattete Geräte oder Speichermedien, wie etwa USB-Speichersticks, können im laufenden Betrieb miteinander verbunden (Hot Swapping) und angeschlossene Geräte sowie deren Eigenschaften automatisch erkannt werden.

USB eignet sich für viele Geräte wie Massenspeicher (etwa Festplatten, Disketten, DVD-Laufwerke; Speichersticks), Drucker, Scanner, Webcams, Mäuse, Tastaturen, Lautsprecher, Dongles, Grafikkarten, Monitore etc. Ein USB-Anschluss kann außerdem für Geräte mit geringem Stromverbrauch wie z.B. Mäuse die Stromversorgung übernehmen.

Aufgrund dieser Vielseitigkeit und der hohen erzielbaren Datenübertragungsrate sind USB-Anschlüsse daher heutzutage sowohl bei Privat- als auch bei Industrie-PCs weit verbreitet.

Allerdings ist die mechanische Festigkeit der Verbindung bei einem USB-Anschluss, d.h. der Verbindung eines USB-Steckers mit einer USB-Buchse, häufig nicht sehr stark. Insbesondere im industriellen Bereich, wo oft Änderungen an den Verbindungen eines PCs vorgenommen werden, tritt daher in der Praxis regelmäßig das Problem auf, dass eine USB-Verbindung unabsichtlich getrennt wird, indem ein Benutzer zum Beispiel versehentlich an einem Kabel hängen bleibt und hierbei einen USB-Stecker aus seiner zugeordneten USB-Buchse an einem Gehäuse eines elektronischen Geräts herauszieht.

Es ist daher Aufgabe der vorliegenden Erfindung, eine Vorrichtung vorzuschlagen, mit der ein an einem Gehäuse eines elektronischen Geräts vorgesehener USB-Gehäuseanschluss weitgehend gegen ein unbeabsichtigtes Herausziehen eines anzuschließenden USB-Gegenanschlusses gesichert werden kann. Derartige Vorrichtungen sind bereits in den Dokumenten US2012/140398 A1, US2009/149055 A1 und Us2012/064753 A1 offenbart.

Erfindungsgemäß wird diese Aufgabe durch einen Sicherungsrahmen für einen an einem Gehäuse eines elektronischen Geräts vorgesehenen USB-Gehäuseanschluss gemäß Anspruch 1 gelöst.

Im Betrieb des elektronischen Geräts mit einem an den USB-Gehäuseanschluss angeschlossenen Peripheriegerät schirmen die Schutzwandabschnitte des Sicherungsrahmens dann den in den USB-Gehäuseanschluss eingesteckten und zum Peripheriegerät führenden USB-Gegenanschluss vor mechanischer Einwirkung ab. Bei Arbeiten an dem entsprechenden Gehäusebereich des elektronischen Geräts stößt der Benutzer allenfalls gegen die Schutzwandabschnitte eine direkte mechanische Einwirkung auf den USB-Gegenanschluss ist jedoch ausgeschlossen. Zweckmäßigerweise ist hierbei vorgesehen, dass die Mittel zur Anbringung des Sicherungsrahmens an dem elektronischen Gerät wenigstens eine Bohrung für eine Schraubverbindung umfassen. Auf diese Weise kann der Sicherungsrahmen stabil an dem elektronischen Gerät befestigt werden, welches hierzu ein Gewinde für die Schraubverbindung aufweisen muss, so dass ein versehentliches Verschieben der Schutzwandabschnitte weg aus der Nähe des USB-Gehäuseanschlusses verhindert wird.

Der Sicherungsrahmen umfasst eine Mehrzahl miteinander verbundener Schutzwandabschnitte, die dazu ausgelegt sind, im Anbringungszustand des Sicherungsrahmens an dem elektronischen Gerät den USB-Gehäuseanschluss im wesentlichen U-förmig zu umgeben. Auf diese Weise wird der USB-Gehäuseanschluss vor mechanischer Einwirkung aus der Mehrzahl der Raumrichtungen geschützt, bleibt jedoch an der offenen Seite des "U" für ein beabsichtigtes Ein- oder Ausstecken des USB-Gegenanschlusses zugänglich.

Vor allem im industriellen Bereich findet sich noch eine Vielzahl von elektrischen und elektronischen Apparaten, die über eine RS232-Schnittstelle oder eine andere Nicht-USB-Schnittstelle anzusteuern sind. Zur Verbindung mit dem betrachteten elektronischen Gerät, das an seinem Gehäuse den USB-Gehäuseanschluss aufweist, ist somit ein Konverter erforderlich, bspw. ein USB-RS232-Konverter. In einer hierfür besonders geeigneten Weiterbildung der bevorzugten Variante der Erfindung mit mehreren miteinander verbundenen Schutzwandabschnitten ist daher vorgesehen, dass wenigstens einer der Schutzwandabschnitte eine Führungsschiene zum Eingriff in eine Rille in einem Gehäuse eines Steckermoduls aufweist, welches an einem Ende einen USB-Gegenanschluss umfasst. Dieses Steckermodul enthält dann den benötigten Konverter und weist an seinem dem USB-Gegenanschluss gegenüberliegenden Ende den erforderlichen anderen Anschluss, also bspw. RS232-Anschluss auf. Durch das Ineinandergreifen der Führungsschiene an dem wenigstens einen Schutzwandabschnitt und der Rille im Gehäuse des Steckermoduls wird die Stabilität und Zuverlässigkeit der mechanischen Verbindung des USB-Anschlusses weiter verbessert.

Zahlreiche elektronische Geräte tragen an ihrem Gehäuse nicht nur einen einzigen, sondern mehrere USB-Gehäuseanschlüsse, die üblicherweise nebeneinander angeordnet sind. Grundsätzlich ist es denkbar, nur einen hiervon durch einen erfindungsgemäßen Sicherungsrahmen zu schützen, bspw. einen besonders wichtigen USB-Gehäuseanschluss. Zweckmäßigerweise ist jedoch vorgesehen, dass der erfindungsgemäße Sicherungsrahmen eine Mehrzahl voneinander beabstandeter Schutzwandabschnitte aufweist, die im Anbringungszustand des Sicherungsrahmens an dem elektronischen Gerät einer Mehrzahl von nebeneinander angeordneten USB-Gehäuseanschlüssen zugeordnet sind.

Wenn der erfindungsgemäße Sicherungsrahmen bspw. wenigstens drei Schutzwandabschnitte aufweist, die in gleichmäßigen Abständen parallel zueinander orientiert sind, so lassen sich zwei benachbarte USB-Gehäuseanschlüsse sowohl nach außen hin als auch voneinander durch jeweils einen Schutzwandabschnitt abschirmen.

In diesen Ausführungsformen mit einer Mehrzahl voneinander beanstandeter Schutzwandabschnitte kann der erfindungsgemäße Sicherungsrahmen insbesondere eine Platte umfassen, welche die Mittel zur Anbringung an dem elektronischen Gerät umfasst, sowie eine Mehrzahl von Wänden, die an der Platte befestigt oder einstückig hiermit ausgebildet sind, wobei die Platte und/oder wenigstens eine der Wände den wenigstens einen Schutzwandabschnitt umfasst. Zweckmäßigerweise verläuft diese Platte nach der Befestigung des Sicherungsrahmens an dem elektronischen Gerät im Wesentlichen parallel zu den USB-Gehäuseanschlüssen, die Wände erstrecken sich zweckmäßigerweise orthogonal von der Platte zwischen den USB-Gehäuseanschlüssen sowie an deren Außenseiten.

In den oben beschriebenen Varianten betrifft die Erfindung rein mechanische Bauteile, mit denen separate elektronische Geräte ausgestattet oder nachträglich erweitert werden können, um die Stabilität der Verbindung von USB-Gehäuseanschlüssen dieser elektronischen Geräte zu erhöhen.

Die Erfindung betrifft in einer Weiterentwicklung außerdem einen USB-Verteiler, umfassend:
- einen erfindungsgemäßen Sicherungsrahmen, wie vorstehend beschrieben;
- einen an dem Sicherungsrahmen angebrachten USB-Gegenanschluss zur Verbindung mit einem in einem Gehäuse eines elektronischen Geräts vorgesehenen USB-Gehäuseanschluss; und
- eine Mehrzahl von an dem Sicherungsrahmen befestigten und mit dem USB-Gegenanschluss verbundenen USB-Anschlüssen, wobei wenigstens einer der USB-Anschlüsse zwischen benachbarten Schutzwandabschnitten des Sicherungsrahmens angeordnet ist.

In dieser Weiterentwicklung erlaubt es die Erfindung somit, einen zunächst ungesicherten USB-Gehäuseanschluss eines elektronischen Geräts auf eine Mehrzahl von gesicherten USB-Anschlüssen des Sicherungsrahmens selbst zu verteilen, dient also als USB-Hub.

Vorzugsweise ist hierbei jeder aus der Mehrzahl von USB-Anschlüssen zwischen benachbarten Schutzwandabschnitten des Sicherungsrahmens angeordnet, so dass jeder der USB-Anschlüsse gegen ein unbeabsichtigtes Herausziehen eines zugeordneten USB-Gegenanschlusses gesichert ist.

Grundsätzlich umfasst der Begriff "Anschluss" sowohl eine Buchse als auch einen Stecker, der Begriff "Gegenanschluss" entsprechend einen Stecker bzw. eine Buchse. Da elektronische Geräte an ihrem Gehäuse regelmäßig mit Buchsen ausgestattet sind, ist zweckmäßigerweise bei dem erfindungsgemäßen USB-Verteiler vorgesehen, dass der USB-Gehäuseanschluss eine USB-Buchse ist, der USB-Gegenanschluss ein USB-Stecker ist, und wenigstens einer der USB-Anschlüsse eine USB-Buchse ist.

Die Erfindung betrifft ferner ein ein System gemäß Anspruch 9.

Da die Breite des Steckermodulgehäuses einem Abstand benachbarter Schutzwandabschnitte entspricht, kann das erfindungsgemäße Steckermodul mit enger Passung in den erfindungsgemäßen Sicherungsrahmen eingeschoben werden, was die Stabilität der Verbindung zwischen dem USB-Anschluss des elektronischen Geräts und dem USB-Gegenanschluss verglichen mit dem bislang betrachteten Fall des Zusammenwirkens mit einem üblichen USB-Gegenanschluss weiter erhöht.

Eine weitere Verbesserung der Stabilität dieser Verbindung lässt sich erzielen, wenn das Steckermodul ferner eine in einer Seitenwand des Steckermodulgehäuses vorgesehene Rille zum Eingriff mit der Führungsschiene des wenigstens einen Schutzwandabschnitts umfasst.

Der an der ersten Stirnwand des erfindungsgemäßen Steckermoduls vorgesehene USB-Gegenanschluss kann der einzige externe Anschluss des Steckermoduls sein, bspw. wenn die darin aufgenommenen elektronischen Komponenten einen USB-Speicherstick, ein Modem etc. bilden. Alternativ kann das erfindungsgemäße Steckermodul ferner einen mit den elektronischen Komponenten verbundenen und an einer der ersten Stirnwand gegenüberliegenden zweiten Stirnwand oder einer Seitenwand vorstehenden Nicht-USB-Anschluss aufweisen, insbesondere einen RS232-Anschluss. Das Steckermodul dient dann der Verbindung des betrachteten elektronischen Geräts mit einem Peripheriegerät über den Nicht-USB-Anschluss.

In einer Weiterentwicklung kann vorgesehen sein, dass eine Seitenwand des Steckermodulgehäuses einen Klemmmechanismus zur Montage auf einer Tragschiene, insbesondere Hutschiene, aufweist. Ein derartiges Steckermodul lässt sich folglich nicht nur in einen erfindungsgemäßen Sicherungsrahmen einschieben, sondern auch auf einer üblichen Hutschiene montieren, und ist somit besonders vielseitig einsetzbar.

Für Einsatzzwecke, bei denen eine besonders starke und sichere Verbindung des USB-Anschlusses benötigt wird, kann das erfindungsgemäße Steckermodul ferner in der Nähe der ersten Stirnwand eine Öffnung zur Verbindung mit dem elektronischen Gerät aufweisen, insbesondere mittels Durchführen einer Schraub- oder Steckverbindung durch die Öffnung. Auf diese Weise kann das Steckermodul doppelt an dem elektronischen Gerät gesichert werden, nämlich einerseits durch enge Passung in dem am elektronischen Gerät befestigten Sicherungsrahmen und andererseits durch die Verbindung mit dem elektronischen Gerät.

Die Erfindung betrifft ferner ein ein System gemäß Anspruch 13.

Die Platine ist dann, im Gegensatz zu herkömmlichen Steckermodulen, nicht in das Steckermodulgehäuse eingeschraubt, sondern wird darin mithilfe des wenigstens einen Stiftes und Bohrung geführt und durch die Zusammenwirkung der Anlagefläche mit dem wenigstens einen Gehäuseteil festgeklemmt. Dies erlaubt eine schnelle Montage und Demontage von Platine und Gehäuse.

Bevorzugte Ausführungsformen der Erfindung werden nachfolgend anhand von nicht-beschränkenden Beispielen unter Bezugnahme auf die beigefügten Figuren erläutert werden. Es zeigen:
- Fig. 1: eine perspektivische Ansicht der Rückseite eines Industrie-PCs 100 mit einem USB-Gehäuseanschluss,
- Fig. 2: eine perspektivische Ansicht eines Sicherungsrahmens 200 für einen an einem Gehäuse eines elektronischen Geräts vorgesehenen USB-Gehäuseanschluss gemäß einer beispielhaften Ausführungsform der vorliegenden Erfindung,
- Fig. 3: eine perspektivische Ansicht eines Steckermoduls 300, welches insbesondere in einem Sicherungsrahmen gemäß der vorliegenden Erfindung verwendet werden kann,
- Fig. 4: eine perspektivische Ansicht eines Sicherungsrahmens 400 für eine Mehrzahl an dem Gehäuse des elektronischen Geräts vorgesehene USB-Gehäuseanschlüsse gemäß einer weiteren beispielhaften Ausführungsform der vorliegenden Erfindung,
- Fig. 5A: eine perspektivische Ansicht der Rückseite eines USB-Verteilers 500 gemäß einer beispielhaften Ausführungsform der vorliegenden Erfindung,
- Fig. 5B: eine perspektivische Ansicht der Vorderseite des USB-Verteilers 500 aus Fig. 5A, und
- Fig. 6: eine perspektivische Explosionsansicht des Steckermoduls 300.

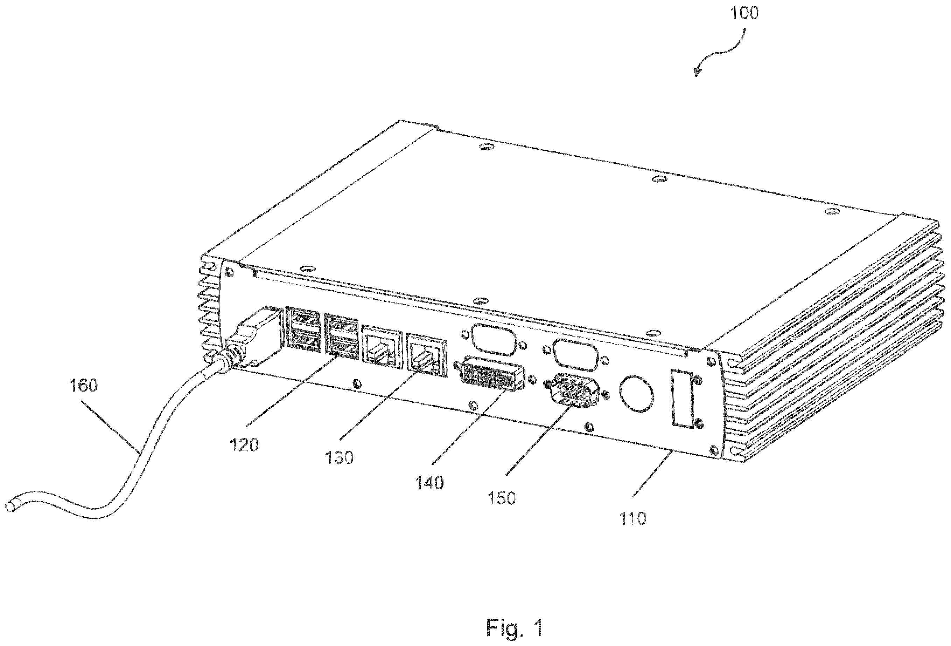

Fig. 1 ist eine perspektivische Ansicht der Rückseite eines Industrie-PCs 100 mit einem USB-Gehäuseanschluss. Ein Industrie-PC ist allgemein ein Computer, der für Aufgaben im industriellen Bereich eingesetzt wird. Der in Fig. 1 gezeigte Industrie-PC 100 ist jedoch nur ein Beispiel eines elektronischen Geräts, mit welchem der erfindungsgemäße Sicherungsrahmen verwendbar ist. Weitere Beispiele für solche elektronischen Geräte umfassen Personal Computer, Server Computer, Router und Wireless Access Point, sofern diese über wenigstens einen USB-Gehäuseanschluss verfügen.

Der in Fig. 1 gezeigte Industrie-PC 100 umfasst ein Gehäuse 110, an dessen Rückseite ein oder mehr Anschlüsse vorgesehen sind. Die Anschlüsse des Industrie-PCs 100 umfassen mehrere USB-Anschlüsse 120 (nachfolgend USB-Gehäuseanschlüsse genannt), zwei Netzwerkanschlüsse 130, einen digitalen Videoanschluss (z. B. Digital Visual Interface, DVI) 140 und einen Nicht-USB-Anschluss 150, insbesondere RS232-Anschluss. Ferner ist der Industrie-PC 100 mittels eines USB-Verbindungskabels 160 über einen der USB-Gehäuseanschlüsse 120 mit einem Peripheriegerät (nicht gezeigt) verbunden.

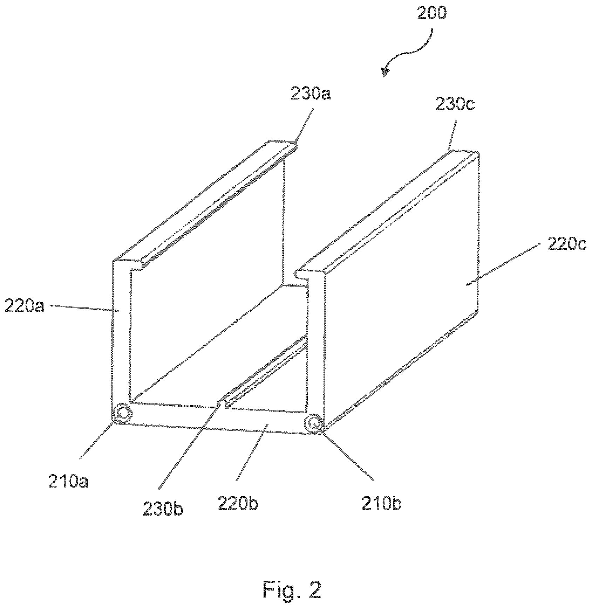

Nachfolgend wird unter Bezugnahme auf Fig. 2 ein Sicherungsrahmen 200 gemäß einer beispielhaften Ausführungsform der vorliegenden Erfindung beschrieben. Fig. 2 ist eine perspektivische Ansicht des Sicherungsrahmens 200.

Der Sicherungsrahmen 200 ist zur Anbringung an einem an einem Gehäuse eines elektronischen Geräts vorgesehenen USB-Gehäuseanschluss vorgesehen. Insbesondere kann der Sicherungsrahmen 200 am Gehäuse 110 des Industrie-PCs 100 von Fig. 1 nahe einem der USB-Gehäuseanschlüsse 120 angebracht werden.

Der Sicherungsrahmen 200 umfasst eine Mehrzahl von Schutzwandabschnitten 220a, 220b, 220c, die derart miteinander verbunden sind, dass sie eine U-Form bilden, und die im Anbringungszustand einen der USB-Gehäuseanschlüsse 120 aus Fig. 1 umgeben. Hierzu ist ein Ende eines ersten Schutzwandabschnitts 220a als ein Seitenwandabschnitt der U-Form mit einem Ende eines zweiten Schutzwandabschnitts 220b als ein Bodenabschnitt der U-Form verbunden, wohingegen das andere Ende des zweiten Schutzwandabschnitts 220b mit einem Ende eines dritten Schutzwandabschnitts 220c als ein weiterer Seitenwandabschnitt der U-Form verbunden ist. Hierbei sind der erste und der dritte Schutzwandabschnitt 220a, 220c im Wesentlichen parallel zueinander. Ferner sind die Schutzwandabschnitte 220a, 220b, 220c derart miteinander verbunden, dass sie jeweils einen rechten Winkel einschließen. Die jeweils anderen Enden der beiden Schutzwandabschnitte 220a, 220c liegen frei. Die Schutzwandabschnitte 220a, 220b, 220c des Sicherungsrahmens 200 sind einstückig gebildet.

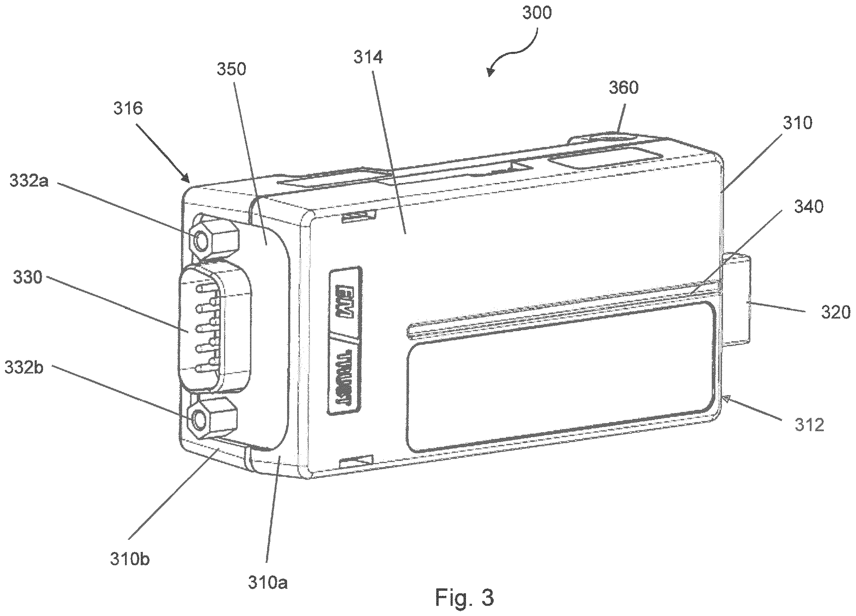

Der Abstand des ersten und des dritten Schutzwandabschnitts 220a, 220c ist dabei so gewählt, dass er einer Breite eines Steckermoduls 300, wie mit Bezug auf Fig. 3 beschrieben, entspricht. Hierdurch kann das Steckermodul 300 mit enger Passung in den Sicherungsrahmen 200 eingeschoben werden, wodurch die Stabilität der Verbindung zwischen dem USB-Gehäuseanschluss des elektronischen Geräts und dem USB-Gegenanschluss 320 des Steckermoduls 300 weiter erhöht wird.

Darüber hinaus umfasst der Sicherungsrahmen 200 zwei Bohrungen für Schraubverbindungen 210a, 210b, welche an Verbindungsbereichen zwischen dem ersten und dem zweiten Schutzwandabschnitt 220a, 220b und zwischen dem zweiten und dem dritten Schutzwandabschnitt 220b, 220c vorgesehen sind. Mittels in die Bohrungen 210a, 210b eingreifende Schraubverbindungen wird der Sicherungsrahmen 200 derart an dem elektronischen Gerät wie z. B. dem Industrie-PC 100 von Fig. 1 angebracht, dass er sich von diesem weg erstreckt. Ferner wird durch die Schraubverbindungen eine sichere Anbringung an dem Industrie-PC 100 von Fig. 1 gewährleistet

Der Sicherungsrahmen 200 umfasst ferner Führungsschienen 230a, 230b, 230c, die jeweils zum Eingriff in eine Rille in einem Gehäuse des mit Bezug auf Fig. 3 beschriebenen Steckermoduls 300 vorgesehen sind. Die Führungsschienen 230a, 230b, 230c sind hierzu insbesondere so in Form und Dimension gebildet, dass sie der jeweiligen Rille des Steckermoduls 300 von Fig. 3 entsprechen.

Die Führungsschienen 230a, 230b, 230c des Sicherungsrahmens 200 sind als Bereiche ausgebildet, welche von der Oberfläche des jeweiligen Schutzwandabschnitts 220a, 220b, 220c vorstehen. Insbesondere sind die Führungsschienen 230a, 230c der Schutzwandabschnitte 220a, 220c an den jeweils freien Enden davon derart vorgesehen, dass sie in entgegengesetzte Richtungen aus den Oberflächen des ersten und dritten Schutzwandabschnitts 220a, 220c vorstehen. Die Führungsschiene 230b ist mittig an dem zweiten Schutzwandabschnitt 220b vorgesehen und steht in einer Richtung vor, welche orthogonal zu den Richtungen ist, in welche die Führungsschienen 230a, 230c vorstehen.

Die Führungsschienen 230a, 230b, 230c sind einstückig mit dem jeweiligen Schutzwandabschnitt 220a, 220b, 220c gebildet.

Nachfolgend wird unter Bezugnahme auf Fig. 3 ein Steckermodul 300 welches mit dem erfindungsgemäßen Sicherungsrahmen 200 verwendet und insbesondere in den Sicherungsrahmen 200 eingeschoben werden kann.

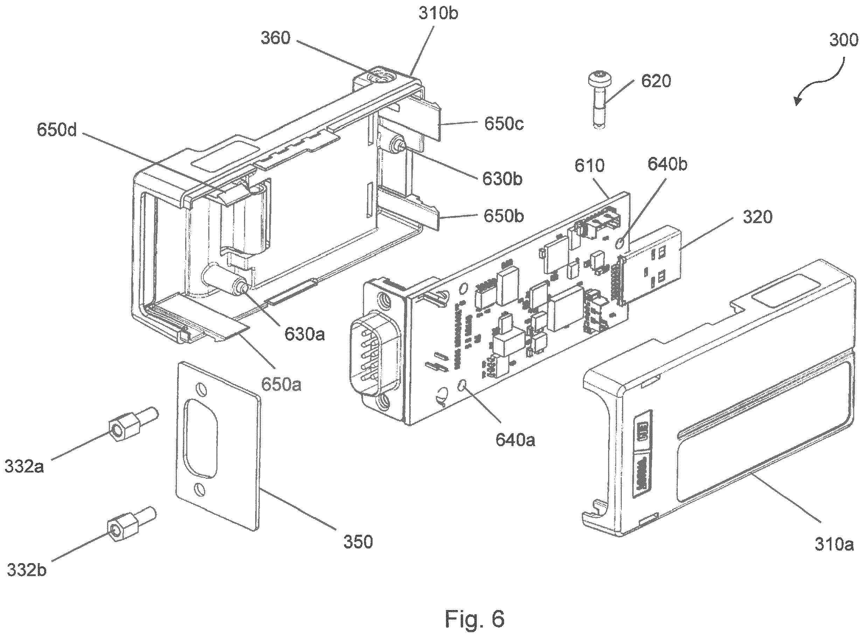

Das Steckermodul 300 umfasst ein Steckermodulgehäuse 310 und einen USB-Gegenanschluss 320, wie z. B. einen USB-Stecker, zum Anschluss an den USB-Gehäuseanschluss des elektronischen Gerätes, wie z. B. einem der USB-Gehäuseanschlüsse 120 des Industrie-PCs 100 aus Fig. 1. In dem Steckermodulgehäuse 310 des Steckermoduls 300 sind elektronische Komponenten (in Fig. 6 gezeigt) aufgenommen, welche mit dem USB-Gegenanschluss 320 verbunden sind. Der USB-Gegenanschluss 320 ist an einer ersten Stirnwand 312 des Steckermodulgehäuses 310 vorgesehen.

Das Steckermodulgehäuse 310 des Steckermoduls 300 umfasst zwei Gehäusehälften 310a, 310b, welche miteinander verbunden sind, wobei die Breite des Steckermodulgehäuses 310 dem Abstand des ersten und des dritten Schutzwandabschnitts 220a, 220c von Fig. 2 entspricht. Hierdurch kann das Steckermodul 300 mit enger Passung in den Sicherungsrahmen 200 von Fig. 2 eingeschoben werden.

In der beispielhaften Ausführungsform von Fig. 3 umfasst das Steckermodul 300 ferner eine in einer Seitenwand 314 des Steckermodulgehäuses 310 vorgesehene Rille 340. Wenn das Steckermodul 300 in den Sicherungsrahmen 200 von Fig. 2 eingeschoben wird, greift die Rille 340 beispielsweise in die Führungsschiene 230a des Schutzwandabschnitts 220a ein.

Die Rille 340 ist so geformt, dass sie der Führungsschiene 230a des Schutzwandabschnitts 220a entspricht und, wenn das Steckermodul 300 in den Sicherungsrahmen 200 eingeschoben ist, formschlüssig mit der Führungsschiene 230a ist. In Fig. 3 erstreckt sich die Rille 340 nur über einen Teil der Länge der Seitenwand 314 des Steckermodulgehäuses 310; sie könnte sich aber auch über deren gesamt Länge erstrecken.

Damit das Steckermodul 300 in den Sicherungsrahmen 200 von Fig. 2 eingeschoben werden kann, weist das Steckermodul 300 neben der Rille 340 noch eine Rille (nicht gezeigt) zum Eingriff mit der Führungsschiene 230c des Schutzwandabschnitts 220c in einer anderen Seitenwand des Steckermodulgehäuses 310, welche der Seitenwand 314 gegenüberliegt, und eine Rille (nicht gezeigt) zum Eingriff mit der Führungsschiene 230b des Schutzwandabschnitts 220b auf.

Weiterhin umfasst das Steckermodul 300 an einer der ersten Stirnwand 312 gegenüberliegenden zweiten Stirnwand 316 einen davon vorstehenden Nicht-USB-Anschluss 330, im gezeigten Fall RS232-Anschluss. Der Anschluss 330 ist mit den elektronischen Komponenten und über diese auch mit dem USB-Gegenanschluss 320 verbunden. Das in Fig. 3 gezeigte Steckermodul 300 ist ein Umwandler von USB auf RS232.

Der RS232-Anschluss 330 ist in einer an der zweiten Stirnseite 316 vorgesehenen Blende 350 angebracht und mittels Schraubmitteln 332a, 332b gesichert.

Das Steckermodul 300 umfasst darüber hinaus eine Öffnung 360 zur Verbindung mit dem elektronischen Gerät, insbesondere mittels einer Schraub- oder Steckverbindung. Die Öffnung 360 ist, wie in Fig. 3 gezeigt, in der Nähe der ersten Stirnwand 312 vorgesehen.

Darüber hinaus umfasst das Steckermodul 300 einen Klemmmechanismus (nicht gezeigt), welcher an der anderen Seitenwand des Steckermodulgehäuses 310 vorgesehen ist. Der Klemmmechanismus ist zur Montage des Steckermoduls 300 auf einer Tragschiene, insbesondere einer Hutschiene, vorgesehen.

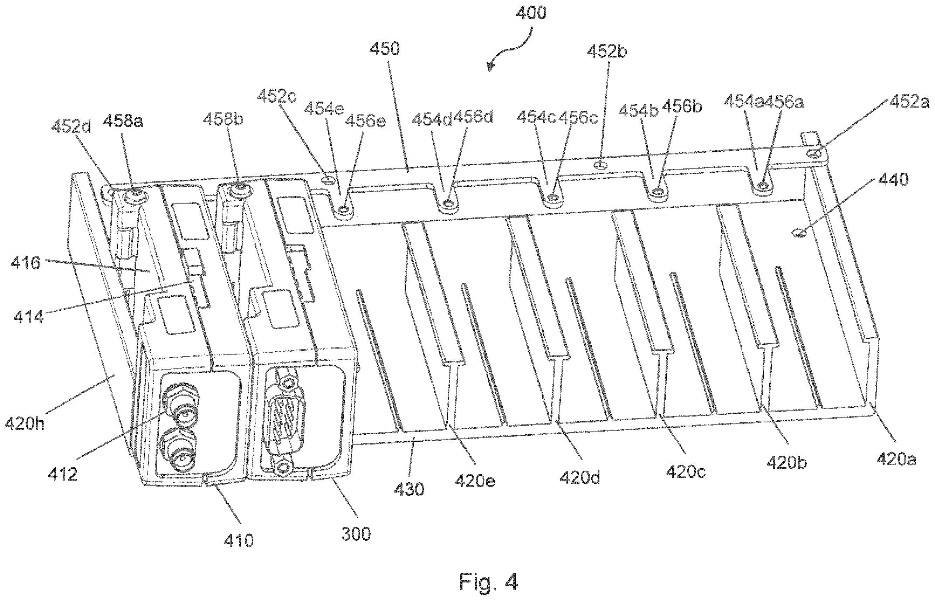

Nachfolgend wird unter Bezugnahme auf Fig. 4 eine weitere beispielhafte Ausführungsform eines Sicherungsrahmens 400 gemäß der vorliegenden Erfindung beschrieben. Fig. 4 ist eine perspektivische Ansicht des Sicherungsrahmens 400 für eine Mehrzahl an dem Gehäuse des elektronischen Geräts vorgesehene USB-Gehäuseanschlüsse.

Der Sicherungsrahmen 400 umfasst eine Platte 430 und eine Mehrzahl voneinander beabstandeter Schutzwandabschnitte 420a - 420h, die im Anbringungszustand des Sicherungsrahmens 400 an einem elektronischen Gerät einer Mehrzahl von nebeneinander angeordneten USB-Gehäuseanschlüssen zugeordnet sind. Die Schutzwandabschnitte 420f und 420g sind verdeckt. Die Schutzwandabschnitte 420a - 420h sind in gleichmäßigen Abständen parallel zueinander orientiert angeordnet und einstückig mit der Platte 430 gebildet.

Die Platte 430 umfasst ferner Mittel zur Anbringung an dem elektronischen Gerät in Form einer Bohrung für eine Schraubverbindung 440.

Die jeweils äußeren Schutzwandabschnitte 420a, 420h weisen in einer Richtung, in welche ein Steckermodul in den Sicherungsrahmen 400 eingeschoben wird, eine Länge auf, die im Wesentlichen der Länge der Platte 430 entspricht. Die weiteren Schutzwandabschnitte 420b - 420f weisen hingegen eine Länge auf, die kürzer als die Länge der äußeren Schutzwandabschnitte 420a, 420h und der Platte 430 ist.

Im Anbringungszustand liegen die beiden äußeren Schutzwandabschnitte 420a, 420h und ein Teil der Platte 430 jeweils an Seitenwänden des Gehäuses des elektronischen Geräts an und der Sicherungsrahmen 400 wird mittels einer Schraubverbindung durch die Bohrung 440 an dem Gehäuse des elektronischen Geräts befestigt. Die Schutzwandabschnitte 420b - 420f sind im Anbringungszustand von der Rückseite des in Fig. 1 gezeigten Industrie-PCs 100 beabstandet oder liegen an dieser an.

In Fig. 4 sind ferner zwei in den Sicherungsrahmen 400 eingeschobene Steckermodule 300, 410 gezeigt. Das Steckermodul 300 entspricht dabei dem in Fig. 3 gezeigten Steckermodul 300, im gezeigten Fall dem Steckermodul 300 mit RS232-Anschluss. Das Steckermodul 410 ist ein Steckermodul, welches - im Aufbau - dem in Fig. 3 gezeigten Steckermodul 300 entspricht, aber einen Anschluss für eine externe Antenne 412 als Nicht-USB-Anschluss und einen Einschub für eine SIM (Subscriber Identity Module) -Karte umfasst. Das Steckermodul 410 ist somit ein Steckermodul 410 zur Verwendung mit einem Mobilfunkstandard wie z. B. GSM (Global System for Mobile Communications). Das Steckermodul 410 weist ebenso wie das Steckermodul 300 den Klemmmechanismus 416 für die Montage auf einer Tragschiene auf.

Der Sicherungsrahmen 400 weist darüber hinaus noch eine weitere Platte 450 mit Mitteln zur Anbringung des Sicherungsrahmens 400 an dem elektronischen Gerät auf, im gezeigten Fall Bohrungen für Schraubverbindungen 452a, 452b, 452c, 452d. Die weitere Platte 450 erstreckt sich parallel zur Platte 430 und orthogonal zu den Schutzwandabschnitten 420a - 420h. Im Anbringungszustand ist die weitere Platte 450 parallel zur Rückseite des elektronischen Gerätes angeordnet.

Die weitere Platte 450 umfasst eine Mehrzahl von Vorsprüngen 454a - 454g zur Sicherung der in den Sicherungsrahmen 400 eingeschobenen Steckermodule 410, 300, wobei die Vorsprünge 454f, 454g verdeckt sind. Insbesondere sind die Vorsprünge 454a - 454g so gebildet, dass sie von der weiteren Platte 450 entgegen der Richtung vorstehen, in welche die Steckermodule 410, 300 in den Sicherungsrahmen 400 eingeschoben werden. Außerdem umfasst jeder der Vorsprünge 454a - 454g eine mit einem Gewinde versehene Bohrung für eine Schraubverbindung 456a - 456g, wobei die Bohrungen 456f, 456g verdeckt sind.

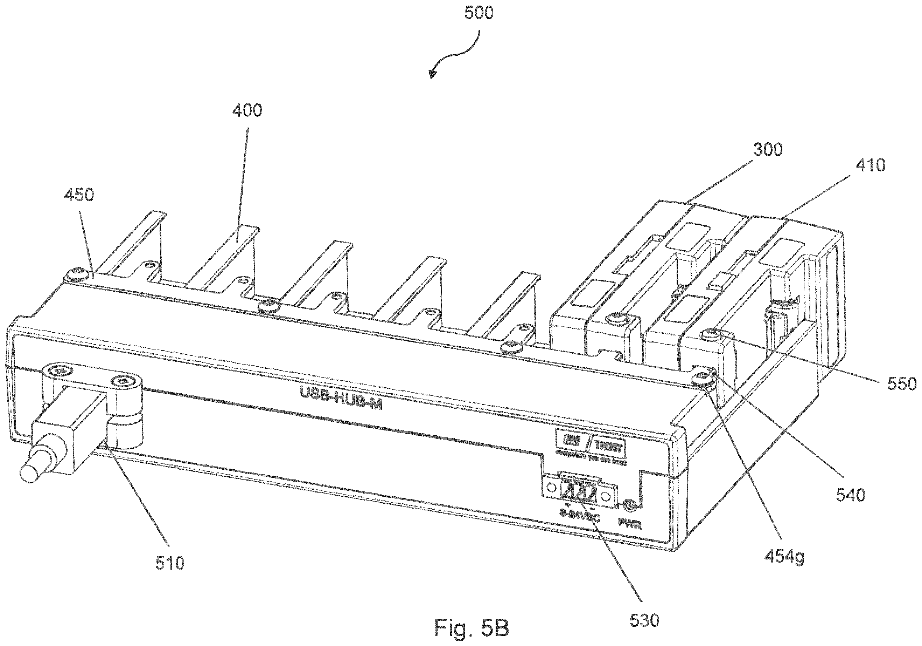

Die Vorsprünge 454a - 454g sind dazu vorgesehen, sich durch entsprechende Durchgänge 540 in das Innere des Steckermoduls 410, 300 zu erstrecken, wie in Fig. 5B gezeigt.

Die durch die Öffnung 360 des jeweiligen Steckermoduls 410, 300 geführten Schraubverbindungen mittels einer Schraube 458a, 458b greifen in das jeweilige Gewinde der Bohrungen 456f, 456g ein, wodurch die Steckermodule 410, 300 gegen den Sicherungsrahmen 400 bzw. das elektronische Gerät gesichert werden und insbesondere ein versehentliches Herausziehen entgegen der Richtung, in welche die Steckermodule 410, 300 in den Sicherungsrahmen 400 eingeschoben sind, verhindert wird.

In einer anderer Ausführungsform der Fig. 4 können die Bohrungen 456a - 456g in den Vorsprüngen 454a - 454g auch ohne Gewinde ausgebildet und jeweils ein Stift, welcher die Schraube 458a, 458b ersetzt, zum Eingriff in die Bohrung vorgesehen sein. Der Stift kann hierbei ebenfalls durch die Öffnung 360 geführt und mittels einer Feder in Richtung der Bohrungen in den Vorsprüngen vorgespannt sein. Die Sicherung des Steckermoduls 410, 300 an dem Sicherungsrahmen 400 bzw. das elektronische Gerät erfolgt beim Einschieben des Steckermoduls 410, 300 in den Sicherungsrahmen 400 durch Führen (z. B. Anheben) des Stiftes in Richtung entgegengesetzt der Vorspannung, bis die Vorsprünge 454a - 454g sich durch die entsprechenden Durchgänge 540 in das Innere des Steckermoduls 410, 300 erstrecken, und darauffolgendes Führen (z. B. Loslassen) des Stiftes in Richtung der Vorspannung derart, dass der vorgespannte Stift durch die Öffnung 360 hindurch in die jeweilige Bohrung 456a - 456g eingreift und das Steckermodul 410, 300 somit an dem Sicherungsrahmen 400 bzw. dem elektronische Gerät sichert.

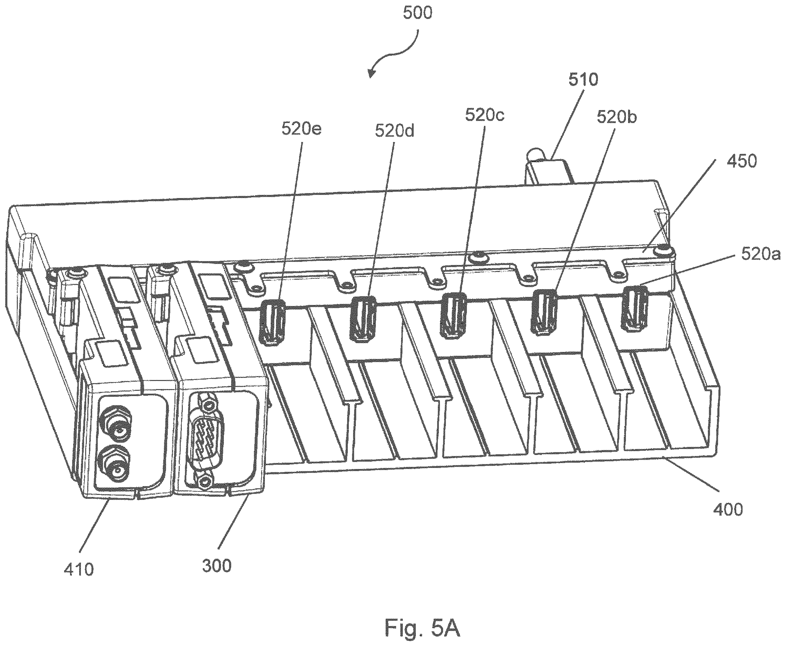

Mit Bezug auf Fig. 5A und 5B wird nachfolgend ein USB-Verteiler 500 (d. h. USB-Hub) gemäß einer Ausführungsform der vorliegenden Erfindung beschrieben. Hierbei ist Fig. 5A eine perspektivische Ansicht der Rückseite des USB-Verteilers 500 und Fig. 5B eine perspektivische Ansicht der Vorderseite des USB-Verteilers 500.

Der USB-Verteiler 500 umfasst einen Sicherungsrahmen 400, wie in Fig. 4 gezeigt, einen an dem Sicherungsrahmen 400 angebrachten USB-Anschluss 510 (nachfolgend USB-Gegenanschluss genannt) zur Verbindung mit einem in einem Gehäuse eines elektronischen Geräts vorgesehenen USB-Gehäuseanschluss und eine Mehrzahl von an dem Sicherungsrahmen 400 befestigten und mit dem USB-Gegenanschluss 510 verbundenen USB-Anschlüssen 520a - 520g, von denen in Fig. 5A nur die USB-Anschlüsse 520a - 520e freiliegen und die USB-Anschlüsse 520f, 520g belegt sind.

Der Sicherungsrahmen 400 und die USB-Anschlüsse 520a - 520g sind an der Rückseite und der USB-Gegenanschluss 510 an der Vorderseite des USB-Verteilers 500 angeordnet.

Die USB-Anschlüsse 520a - 520g sind dabei so angeordnet, dass sie jeweils zwischen benachbarten Schutzwandabschnitten des Sicherungsrahmens 400 positioniert sind.

Der Sicherungsrahmen 400 ist ferner mit der oben beschriebenen weiteren Platte 450 versehen, welche mittels Schraubverbindungen an dem USB-Verteiler angebracht ist.

In den Fig. 5A und 5B sind, wie in Fig. 4, zwei in den Sicherungsrahmen 400 des USB-Verteilers 500 eingeschobene Steckermodule 410, 300 an den USB-Anschlüssen 520f, 520g gezeigt.

Wie in Fig. 5B gezeigt, umfasst der USB-Verteiler 500 an seiner Vorderseite einen Anschluss 530 zur Verbindung mit einer externen Stromversorgung (nicht gezeigt), wie z. B. einem externen Netzteil.

Der Vorsprung 454g der weiteren Platte 450 greift in einen in der ersten Stirnwand des Steckermoduls 410 vorgesehenen Durchgang 540 ein, wenn das Steckermodul 410 in den Sicherungsrahmen 400 eingeschoben ist. Die Sicherung des Steckermoduls 410 erfolgt durch eine Schraubverbindung mittels einer Schraube 550, welche durch die in Fig. 3 gezeigte Öffnung 260 im Steckermodul 410 geführt ist und in das Gewinde der Bohrung (nicht gezeigt) in dem Vorsprung 454g eingreift.

Fig. 6 zeigt eine perspektivische Explosionsansicht des Steckermoduls 300 von Fig. 3. Das Steckermodul 300 ist zur Verwendung mit dem Sicherungsrahmen 200 gemäß Fig. 2 und dem Sicherungsrahmen 400 gemäß Fig. 4 vorgesehen, d. h. zum Einschub darin. Das Steckermodulgehäuse 310 weist daher eine Breite auf, die dem Abstand benachbarter Schutzwandabschnitte entspricht.

Das Steckermodul 300 umfasst, wie in Fig. 3 gezeigt, ein Steckermodulgehäuse 310, das zwei miteinander verbundene Gehäuseteile 310a, 310b umfasst, in dem Steckermodulgehäuse 310 aufgenommene elektronische Komponenten und einen mit den elektronischen Komponenten verbundenen und an der ersten Stirnwand des Steckermodulgehäuses 310 vorgesehenen USB-Gegenanschluss 320, Das Steckermodul 300 von Fig. 6 weist ferner den Nicht-USB-Anschluss 330, im gezeigten Fall RS232-Anschluss auf, welcher an der zweiten Stirnwand vorsteht.

Die Gehäuseteile 310a, 310b des Steckermoduls 300 weisen in das Innere des Steckermodulgehäuses 310 vorstehende Stifte 630a, 630b auf. Die elektronischen Komponenten sind auf einer in dem Steckermodulgehäuse 310 angeordneten Platine 510 befestigt. Die Platine weist Bohrungen 640a, 640b zur Aufnahme der Stifte 630a, 630b auf.

Außerdem umfasst die Platine 610 oder eine der auf der Platine 610 befestigten elektronischen Komponenten eine Anlagefläche (nicht gezeigt) zur Anlage an wenigstens einem der miteinander verbundenen Gehäuseteile 310a, 310b.

Die Gehäuseteile 310a, 310b werden gemäß der in Fig. 6 gezeigten Ausführungsform lösbar unter Verwendung einer Schnappverbindung (im gezeigten Fall am Gehäuseteil 310b vorgesehene Schnapphaken 650a, 650b, 650c, 650d und am Gehäuseteil 310a vorgesehene Hinterschneidungen) miteinander verbunden.

Das Steckermodul 300 umfasst die Öffnung 360 zur Verbindung mit dem elektronischen Gerät oder dem Sicherungsrahmen, z. B. unter Verwendung der Schraube 620.

## Patentansprüche

1. Sicherungsrahmen (200, 400) für einen an einem Gehäuse (110) eines elektronischen Geräts (100) vorgesehenen USB-Gehäuseanschluss (120), wobei der Sicherungsrahmen (200, 400) Mittel zur Anbringung an dem elektronischen Gerät sowie eine Mehrzahl miteinander verbundener Schutzwandabschnitte (220a - 220c; 420a - 420h, 430) umfasst, die dazu ausgelegt sind, sich im Anbringungszustand des Sicherungsrahmens (200, 400) an dem elektronischen Gerät (100) nahe dem USB-Gehäuseanschluss (120) wenigstens teilweise von dem Gehäuse (110) weg zu erstrecken und im Anbringungszustand des Sicherungsrahmens (200, 400) an dem elektronischen Gerät (100) den USB-Gehäuseanschluss (120) im wesentlichen U-förmig derart zu umgeben, dass der USB-Gehäuseanschluss (120) für ein Ein- oder Ausstecken eines USB- Gegenanschlusses (320) zugänglich bleibt, wobei wenigstens einer der Schutzwandabschnitte (220a - 220c) eine Führungsschiene (230a - 230c) zum Eingriff in eine Rille (340) in einem Gehäuse (310) eines Steckermoduls (300) aufweist, welches an einem Ende den USB-Gegenanschluss (320) umfasst.

2. Sicherungsrahmen (200, 400) nach Anspruch 1, **dadurch gekennzeichnet, dass** die Mittel zur Anbringung des Sicherungsrahmens an dem elektronischen Gerät wenigstens eine Bohrung für eine Schraubverbindung (210a, 210b; 440) umfassen.

3. Sicherungsrahmen (400) nach einem der vorhergehenden Ansprüche, **dadurch gekennzeichnet, dass** eine Mehrzahl derSchutzwandabschnitte (420a - 420h) voneinander beabstandet sind, die im Anbringungszustand des Sicherungsrahmens (400) an dem elektronischen Gerät (100) einer Mehrzahl von nebeneinander angeordneten USB-Gehäuseanschlüssen (120) zugeordnet sind.

4. Sicherungsrahmen (400) nach Anspruch 3, **dadurch gekennzeichnet, dass** wenigstens drei der Schutzwandabschnitte (420a - 420h) in gleichmäßigen Abständen parallel zueinander orientiert sind.

5. Sicherungsrahmen (400) nach Anspruch 3 oder 4, **dadurch gekennzeichnet, dass** er eine Platte (430) aufweist, welche die Mittel zur Anbringung (440) an dem elektronischen Gerät umfasst, sowie eine Mehrzahl von Wänden (420a - 420h), die an der Platte (430) befestigt oder einstückig hiermit ausgebildet sind, wobei die Platte (430) und/oder wenigstens eine der Wände (420a - 420h) einen der Schutzwandabschnitte umfasst.

6. USB-Verteiler (500), umfassend:
- einen Sicherungsrahmen (400) nach einem der Ansprüche 3-5;
- einen an dem Sicherungsrahmen (400) angebrachten USB-Gegenanschluss (510) zur Verbindung mit einem in einem Gehäuse (110) eines elektronischen Geräts (100) vorgesehenen USB-Gehäuseanschluss (120); und
- eine Mehrzahl von an dem Sicherungsrahmen (400) befestigten und mit dem USB-Gegenanschluss (510) verbundenen USB-Anschlüssen (520a - 520g), wobei wenigstens einer der USB-Anschlüsse (520a - 520g) zwischen den voneinander beabstandeten Schutzwandabschnitten (420a - 420h) des Sicherungsrahmens (400) angeordnet ist.

7. USB-Verteiler (500) nach Anspruch 6, **dadurch gekennzeichnet, dass** jeder aus der Mehrzahl von USB-Anschlüssen (520a - 520g) zwischen benachbarten Schutzwandabschnitten (420a - 420h) des Sicherungsrahmens (400) angeordnet ist.

8. USB-Verteiler (500) nach einem der Ansprüche 6 oder 7, **dadurch gekennzeichnet, dass** der USB-Gehäuseanschluss (120) eine USB-Buchse ist, der USB- Gegenanschluss (510) ein USB-Stecker ist, und wenigstens einer der USB-Anschlüsse (520a - 520g) eine USB-Buchse ist.

9. System umfassend einen Sicherungsrahmen (400) nach einem der Ansprüche 3-5 und ein Steckermodul (300) zur Verwendung in dem Sicherungsrahmen (400),
das Steckermodul (300) umfassend:
- ein Steckermodulgehäuse (310) mit darin aufgenommenen elektronischen Komponenten, wobei eine Breite des Steckermodulgehäuses (310) einem Abstand zwischen den voneinander beabstandeten Schutzwandabschnitten (420a - 420h) entspricht;
- einen mit den elektronischen Komponenten verbundenen und an einer ersten Stirnwand (312) des Steckermodulgehäuses (310) vorgesehenen USB-Gegenanschluss (320); und
- eine in einer Seitenwand (314) des Steckermodulgehäuses (310) vorgesehene Rille (340) zum Eingriff mit der Führungsschiene (230a - 230c) des wenigstens einen Schutzwandabschnitts (420a - 420h).

10. System nach Anspruch 9, **dadurch gekennzeichnet, dass** das Steckermodul (300) ferner einen mit den elektronischen Komponenten verbundenen und an einer der ersten Stirnwand (312) gegenüberliegenden zweiten Stirnwand (316) oder einer Seitenwand (314) vorstehenden Nicht-USB-Anschluss (330) aufweist.

11. System nach einem der Ansprüche 9-10, **dadurch gekennzeichnet, dass** eine Seitenwand des Steckermodulgehäuses (310) einen Klemmmechanismus (416) zur Montage auf einer Tragschiene aufweist.

12. System nach einem der Ansprüche 9-11, **dadurch gekennzeichnet, dass** das Steckermodul (300) ferner in der Nähe der ersten Stirnwand (312) eine Öffnung (360) zur Verbindung mit dem elektronischen Gerät (100) aufweist.

13. System nach einem der Ansprüche 9-12, wobei das Steckermodulgehäuse (310) zwei miteinander verbundene Gehäuseteile (310a, 310b) umfasst, die wenigstens einen in das Innere des Steckermodulgehäuses (310) vorstehenden Stift (630a, 630b) aufweisen, und umfassend eine in dem Steckermodulgehäuse (310) angeordnete Platine (610), die wenigstens eine Bohrung (640a, 640b) zur Aufnahme des wenigstens einen Stiftes (630a, 630b) aufweist.

14. System nach Anspruch 13, **dadurch gekennzeichnet, dass** die Platine (610) oder eine auf der Platine (610) befestigte elektronische Komponente ferner wenigstens eine Anlagefläche zur Anlage an wenigstens einem der miteinander verbundenen Gehäuseteile (310a, 310b) aufweist.

## Claims

1. Securing frame (200, 400) for a USB housing connection (120) provided on a housing (110) of an electronic device (100), wherein the securing frame (200, 400) comprises means for attaching to the electronic device, as well as a plurality of mutually connected protection wall sections (220a - 220c; 420a - 420h, 430), which are configured such that, in the connected state of the securing frame (200, 400) to the electronic device (100), close to the USB housing connection (120), they extend at least partially away from the housing (110), and, in the attachment state of the securing frame (200, 400) to the electronic device (100), they surround the USB housing connection (120) in an essentially U-shape, in such a way that the USB housing connection (120) remains accessible for plugging or unplugging a USB counter-connection (320), wherein at least one of the protection wall sections (220a - 220c) comprises a guide rail (230a - 230c) for engaging in a slot (340) in a housing (310) of a plug module (300), which at one end comprises the USB counter-connection (320).

2. Securing frame (200, 400) according to claim 1, **characterized in that** the means for attaching the securing frame to the electronic device comprise at least one borehole for a screw connection (210a, 210b; 440).

3. Securing frame (400) according to any one of the preceding claims, **characterized in that** a plurality of the protection wall sections (420a - 420h) are arranged at a distance from one another, which in the attachment state of the securing frame (400) to the electronic device (100) are allocated to a plurality of USB housing connections (120) arranged next to one another.

4. Securing frame (400) according to claim 3, **characterized in that** at least three of the protection wall sections (420a - 420h) are oriented parallel to one another and at uniform distance intervals from one another.

5. Securing frame (400) according to claim 3 or 4, **characterized in that** it comprises a plate (430), which comprises the means for attachment (440) to the electronic device, as well as a plurality of walls (420a - 420h) which are secured to the plate (430) or formed as being of one piece with it, wherein the plate (430) and/or at least one of the walls (420a - 420h) comprises one of the protection wall sections.

6. USB distributor (500), comprising:
- A securing frame (400) according to any one of claims 3-5;
- a USB counter-connection (510) attached to the securing frame (400), for connecting to a USB housing connection (120) provided in a housing (110) of an electronic device (100); and
- a plurality of USB connections (520a - 520g) secured to the securing frame (400) and connected to the USB counter-connection (510), wherein at least one of the USB connections (520a - 520g) is arranged between the protection wall sections (420a - 420h) of the securing frame (400) spaced at a distance from one another.

7. USB distributor (500) according to claim 6, **characterized in that** each of the plurality of USB connections (520a - 520g) is arranged between adjacent protection wall sections (420a - 420h) of the securing frame (400).

8. USB distributor (500) according to any one of claims 6 or 7, **characterized in that** the USB housing connection (120) is a USB socket, the USB counter-connector (510) is a USB plug, and at least one of the USB connections (520a - 520g) is a USB socket.

9. System comprising a securing frame (400) according to any one of claims 3-5, and a plug module (300) for use in the securing frame (400), the plug module (300) comprising:
- a plug module housing (310) with electronic components accommodated within it, wherein a width of the plug module housing (310) corresponds to a distance interval between the protection wall sections (420a - 420h) spaced at a distance from one another;
- a USB counter-connection (320) connected to the electronic components and provided at a first face wall (312) of the plug module housing (310); and
- a slot (340) provided in a side wall (314) of the plug module housing (310), for engaging with the guide rail (230a - 230c) of the at least one protection wall sections (420a - 420h).

10. System according to claim 9, **characterized in that** the plug module (300) further comprises a second face wall (316), connected to the electronic components and located opposite the first face wall (312), or comprises a non-USB connection (330) projecting at a side wall (314).

11. System according to any one of claims 9-10, **characterized in that** a side wall of the plug module housing (310) comprises a clamp mechanism (416) for mounting on a carrier rail.

12. System according to any one of claims 9-11, **characterized in that** the plug module (300) further comprises, close to the first face wall (312), an opening (360) for the connection to the electronic device (100).

13. System according to any one of claims 9-12, **characterized in that** the plug module housing (310) comprises two housing parts (310a, 310b) connected to one another, which comprise at least one pin (630a, 630b) projecting into the interior of the plug module housing (310), and comprising a printed circuit board (610) arranged in the plug module housing (310), which comprises at least one borehole (640a, 640b) for accommodating the at least one pin (630a, 630b).

14. System according to claim 13, **characterized in that** the printed circuit board (610), or an electronic component secured to the printed circuit board (610), further comprises at least one contact surface for contact with at least one of the housing parts (310a, 310b) connected to one another.

## Revendications

1. Cadre de sécurité (200, 400) pour un connecteur USB (120) de boîtier prévu sur un boîtier (110) d'un appareil électronique (100), le cadre de sécurité (200, 400) comprenant des moyens de montage sur l'appareil électronique et une pluralité de parties de paroi de protection interconnectées (220a -220c ; 420a - 420h, 430) configurées de façon à s'étendre, dans l'état de montage du cadre de sécurité (200, 400) sur l'appareil électronique (100), au moins partiellement en éloignement du boîtier (110) à proximité du connecteur USB (120) de boîtier et à entourer le connecteur USB (120) de boîtier sensiblement selon une forme de U dans l'état de montage du cadre de sécurité (200, 400) sur l'appareil électronique (100), de sorte que le connecteur USB (120) de boîtier reste accessible pour l'insertion ou le retrait d'un connecteur USB (320) complémentaire, au moins l'une des parties de paroi de protection (220a - 220c) comprenant un rail de guidage (230a - 230c) destiné à s'engager dans une rainure (340) dans un boîtier (310) d'un module enfichable (300) qui comprend le connecteur USB (320) complémentaire à une extrémité.

2. Cadre de sécurité (200, 400) selon la revendication 1, **caractérisé en ce que** les moyens de fixation du cadre de sécurité à l'appareil électronique comprennent au moins un trou pour un vissage (210a, 210b ; 440).

3. Cadre de sécurité (400) selon l'une des revendications précédentes, **caractérisé en ce qu'**une pluralité desdites parties de paroi de protection (420a - 420h) sont espacées les unes des autres et sont associées à une pluralité de connecteurs USB (320) complémentaires disposés côte à côte dans l'état de montage du cadre de sécurité (400) sur l'appareil électronique (100).

4. Cadre de sécurité (400) selon la revendication 3, **caractérisé en ce qu'**au moins trois des parties de paroi de protection (420a - 420h) sont orientées parallèlement les unes aux autres à intervalles réguliers.

5. Cadre de sécurité (400) selon la revendication 3 ou la revendication 4, **caractérisé en ce qu'**il comprend une plaque (430) comprenant les moyens de fixation (440) à l'appareil électronique, et une pluralité de parois (420a - 420h) fixées à la plaque (430) ou formées d'un seul tenant avec celle-ci, la plaque (430) et/ou au moins l'une des parois (420a - 420h) comprenant l'une des parties de paroi de protection.

6. Répartiteur USB (500), comprenant :
- un cadre de sécurité (400) selon l'une des revendications 3 à 5 ;
- un connecteur USB (510) complémentaire monté sur le cadre de sécurité (400) pour la connexion à un connecteur USB (120) de boîtier prévu dans un boîtier (110) d'un appareil électronique (100) ; et
- une pluralité de connecteurs USB (520a - 520g) fixés au cadre de sécurité (400) et connectés au connecteur USB (510) complémentaire, au moins l'un des connecteurs USB (520a - 520g) étant disposé entre les parties de paroi de protection (420a - 420h) du cadre de sécurité (400) qui sont espacées les unes des autres.

7. Répartiteur USB (500) selon la revendication 6, **caractérisé en ce que** chaque connecteur de la pluralité de connecteurs USB (520a - 520g) est situé entre des parties de paroi de protection adjacentes (420a - 420h) du cadre de sécurité (400).

8. Répartiteur USB (500) selon l'une des revendications 6 ou 7, **caractérisé en ce que** le connecteur USB (120) de boîtier est un connecteur USB femelle, le connecteur USB (510) est un connecteur USB mâle, et au moins un des connecteurs USB (520a - 520g) est un connecteur USB femelle.

9. Système comprenant un cadre de sécurité (400) selon l'une des revendications 3 à 5 et un module enfichable (300) destiné à être utilisé dans le cadre de sécurité (400), le module enfichable (300) comprenant :
- un boîtier (310) de module enfichable dans lequel sont logés des composants électroniques, une largeur du boîtier (310) de module enfichable correspondant à une distance entre les parties de paroi de protection (420a - 420h) espacées les unes des autres ;
- un connecteur USB (320) complémentaire connecté aux composants électroniques et prévu sur une première paroi d'extrémité (312) du boîtier (310) de module enfichable ; et
- une rainure (340) prévue dans une paroi latérale (314) du boîtier (310) de module enfichable de façon à venir en prise avec le rail de guidage (230a - 230c) de ladite au moins une partie de paroi de protection (420a - 420h).

10. Système selon la revendication 9, **caractérisé en ce que** le module enfichable (300) comprend en outre un connecteur non USB (330) relié aux composants électroniques et faisant saillie sur une deuxième paroi d'extrémité (316) opposée à la première paroi d'extrémité (312) ou sur une paroi latérale (314).

11. Système selon l'une des revendications 9 à 10, **caractérisé en ce qu'**une paroi latérale du boîtier (310) de module enfichable comprend un mécanisme de serrage (416) pour le montage sur un rail de support.

12. Système selon l'une des revendications 9 à 11, **caractérisé en ce que** le module enfichable (300) comprend en outre, à proximité de la première paroi d'extrémité (312), une ouverture (360) pour la connexion avec l'appareil électronique (100).

13. Système selon l'une des revendications 9 à 12, dans lequel le boîtier (310) de module enfichable comprend deux parties de boîtier (310a, 310b) reliées entre elles et présentant au moins un plot (630a, 630b) faisant saillie à l'intérieur du boîtier (310) de module enfichable, et comprenant une carte à circuit imprimé (610) disposée dans le boîtier (310) de module enfichable et présentant au moins un alésage (640a, 640b) destiné à recevoir ledit au moins un plot (630a, 630b).

14. Système selon la revendication 13, **caractérisé en ce que** la platine (610) ou un composant électronique fixé sur la platine (610) présente en outre au moins une surface d'appui pour un appui sur au moins une des parties de boîtier (310a, 310b) reliées entre elles.
